# EUROPEAN PATENT SPECIFICATION

(11) **EP 1 783 549 B1**
(45) Date of publication and mention of the grant of the patent: **15.10.2008**
(21) Application number: 05765716.5
(22) Date of filing: 12.07.2005
(51) Int. Cl.: B41C 1/10, B41M 5/36

(54) **POSITIVE PHOTOSENSITIVE COMPOSITION**
POSITIVE LICHTEMPFINDLICHE ZUSAMMENSETZUNG
COMPOSITION PHOTOSENSIBLE POSITIVE

(30) Priority: 27.08.2004 JP 2004248590
(43) Date of publication of application: 09.05.2007
(73) Proprietor: THINK LABORATORY CO., LTD., Chiba, 227-8525 (JP)
(72) Inventor: SATO, Tsutomu, Kashiwa-shi, Chiba 2778525 (JP)
(74) Representative: Grünecker, Kinkeldey, Stockmair & Schwanhäusser Anwaltssozietät
(86) International application number: PCT/JP2005/012826
(87) International publication number: WO 2006/022086

(56) References cited:
- EP-A- 1 258 351
- JP-A- 9 244 226
- JP-A- 11 506 550
- JP-A- 2002 090 984
- JP-A- 2002 189 294
- JP-A- 2002 303 983
- JP-A- 2003 337 408
- JP-A- 2003 345 017
- JP-A- 2004 133 025
- JP-A- 2004 138 758
- US-A1- 2004 014 831

## Description

The present invention relates to a positive photosensitive composition, more specifically, an alkali-soluble positive photosensitive composition which has such an infrared wavelength range laser sensitivity that the composition is exposed to a laser ray having a wavelength of 700 to 1,100 nm so as to be sensitized and then the sensitized portion becomes soluble in an alkaline developing solution, and which is not required to be subjected to heat treatment (burning) after coating. The positive photosensitive composition of the present invention can be used effectively for photo-fabrication, and can be in particular preferably used in the field of photo-fabrication which is applied to the production of a printing plate, an electric member, a precision instrument member, a member related to forgery prevention, or the like.

In recent years, there have been proposed positive photosensitive compositions which have such a near infrared wavelength range laser sensitivity that the compositions are exposed to a near infrared wavelength range laser so as to be sensitized and then the sensitized portion becomes soluble in a developing solution (refer to, for example, Patent Documents 1 and 2, and so on). However, these positive photosensitive compositions have a problem that the compositions are low in adhesive property to the surface of a support so that images are easily peeled.

Any conventional positive photosensitive composition is required to be subjected to heat treatment (burning) after the composition is coated onto the surface of a support, and is required to be cooled after the burning. Thus, time and energy are necessary for the burning and the subsequent cooling. Furthermore, the apparatus line therefor becomes long by the length of its burning device, so that equipment costs and running costs therefor increase. The conventional positive photosensitive composition has such problems. Furthermore, in the case of a gravure roll, the roll has a large heat load unlike a thin plate material so that long time is required for heating and cooling the roll. Moreover, there is a problem that the heating and cooling time is varied in accordance with the size and the thickness of the roll and the roll material of iron or aluminum, with the result that the time cannot be simply controlled. Also, the practice of the burning causes a colorant such as a cyanine colorant to be denatured, leading to reduced sensitivity falls and low sharpness of a pattern, and also at the time of development causes the resist to be thin which is a cause of the retardation of an outline and the generation of pinholes. It has been therefore desired to develop a positive photosensitive film free from the necessity of burning.

Patent Document 3 discloses a positive photosensitive composition comprising a resin having a phenolic hydroxyl group, a light absorptive colorant, and a heterocyclic thiol in order to improve the adhesion. However, the composition disclosed in Patent Document 3 is also required to be subjected to heat treatment after the composition is coated onto the surface of a support in order to form an image.

Patent Document 4 describes a positive photosensitive composition comprising a resin having a group decomposable by action of an acid to become alkali-soluble, a photo-acid generator, and a compound having a mercapto group. However, the composition requires not only heat treatment after the composition is coated onto the surface of a support but also heat treatment (PEB) after the composition is exposed to light. Patent Document 4 discloses a positive photosensitive composition wherein the photo-acid generator generates an acid by PEB and the resin becomes alkali-soluble by action of the acid. The composition of Patent Document 4 is entirely different from the positive photosensitive composition of the present invention in terms of composition and usage.
Patent Document 1: JP-A No.11-174681
Patent Document 2: JP-A No. 11-231515
Patent Document 3: JP-A No. 2003-337408
Patent Document 4: JP-A No. 2004-138758
Patent Document 5: JP-B No. 47-25470
Patent Document 6: JP-B No. 48-85679
Patent Document 7: JP-B No. 51-21572
US 2004/0014831 A1 describes a resin composition that alters its solubility in an alkaline aqueous solution by exposure to infrared, and a resin composition useful for an image recording layer of positive or negative type planogaphic printing plate precursors.
EP 1258351 A2 discloses a photosensitive composition, which is suited to be directly written on by a laser and is superior in storage stability, a photosensitive lithographic printing plate, and a process for producing lithographic printing plate.

An object of the present invention is to provide a positive photosensitive composition which is excellent in adhesion and requires neither heat treatment after the composition is coated onto an object nor heat treatment after being exposed to light.

The present invention is solved on the basis of claims 1 to 12.
In order to solve the above-mentioned problems, the positive photosensitive composition of the present invention, which does not require heat treatment after the composition is coated, comprises: (A) an alkali-soluble high molecular substance having in the molecule thereof at least one carboxyl group, (B) a photo-thermal conversion material which absorbs infrared rays from an image exposure light source to convert the rays to heat, (C) a thiol compounds and (D) a dissolution inhibitor represented by chemical Formula (2).

The high molecular substance (A) is preferably at least one polymer selected from the group consisting of a polymer obtained from an unsaturated compound (a1) having at least one carboxyl group and/or at least one carboxylic acid anhydride group and a copolymer obtained from the unsaturated compound (a1) and a compound (a2) copolymerizable with the unsaturated compound.

The unsaturated compound (a1) is preferably at least one compound selected from the group consisting of maleic acid, (meth)acrylic acid and their derivatives. In the present invention, acryl and methacryl are collectively called (meth)acryl.

The high molecular substance (A) is preferably at least one polymer selected from the group consisting of a maleic acid polymer, a (meth)acrylic acid polymer, a styrene/maleic acid copolymer and their derivatives.

The high molecular substance (A) is preferably a reactant of a high molecular substance having a carboxylic acid anhydride group and a compound having a hydroxyl group, and is more preferably a styrene/maleic acid copolymer obtained by reacting a styrene/maleic anhydride copolymer with a compound having a hydroxyl group. The compound having a hydroxyl group is preferably an alcohol.

The high molecular substance (A) is preferably a polymer represented by the following general formula (1):

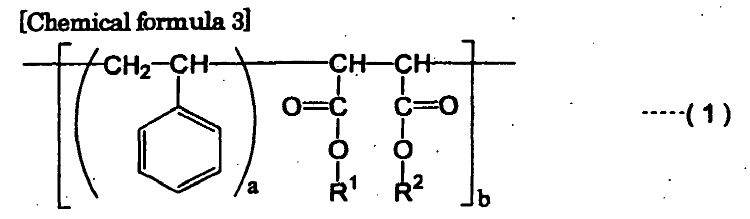

In the formula (1), "R¹" and "R²" each independently represent a hydrogen atom or a substituted or unsubstituted alkyl group, "a" is an integer of 1 to 3, and "b" is an integer of 6 to 8.

The thiol compound (C) is preferably 2-mercaptobenzooxazol.

The dissolution inhibitor (D) is a compound represented by the following chemical formula (2):

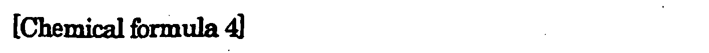

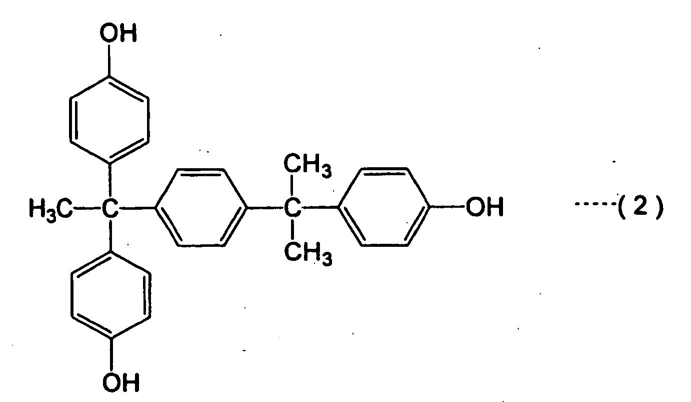

A photo-fabrication method of the present invention comprises the use of the positive photosensitive composition of the present invention. The photo-fabrication method is preferably applied to production of a printing plate, an electronic component, a precision equipment component or a component relating to a counterfeit deterrence.

A plate-making method of the present invention comprises the use of the positive photosensitive composition of the present invention. Printing plates such as an intaglio (gravure), lithography, relief and mimeograph may be produced by the plate-making method of the present invention.

A general plate-making process of a gravure plate using the positive photosensitive composition of the present invention as a sensitizing solution is as follows.
1. Application of a sensitizing solution to a cylinder (dry film thickness: preferably 2 to 5 µm, the film is preferably thicker to reduce pinholes, but the film is preferably thinner because the amount of the solution to be used is reduced and the production cost is reduced that much) → 2. Drying (until touch dry: 15 minutes → until end: 15 to 20 minutes) → 3. Exposure (light source: semiconductor laser 830 nm, 220 mJ/cm²) → 4. Development (60 to 90 seconds/25°C) → 5. Washing with water (spray, 30 seconds) → 6. Etching (depth: 10 to 30 µm, etching: a solution of cupric chloride in water, conversion of copper: 60 g/L) → 7. Peeling of resist (peeling using an alkali) → 8. Washing with water → 9. Cr plating (chromic acid: 250 g/L, sulfuric acid: 2.5 g/L in water) → 10. Washing with water → 11. Printing.

A general plate-making process of a lithography (PS plate) using the positive photosensitive composition of the present invention as a sensitizing solution is as follows.
1. CTP (PS plate) (aluminum abrasion → application of a sensitizing solution → drying) → 2. Exposure (light source: semiconductor laser 830 nm, 220 mJ/cm²) → 3. Development → 4. Printing.

The positive photosensitive composition of the present invention is alkali-soluble positive photosensitive composition that is sensitized when exposed to laser light in the infrared wavelength region wherein the exposed portion becomes soluble in a developing solution. The composition has the following excellent effects.
(1) Necessary and sufficient adhesion to aluminum and copper as well as even to a less adhesive subject to be coated such as glossy and mirror-like plated copper can be obtained without burning. Also, even though burning is not carried out, a photosensitive film having the same glossiness as in the conventional case of carrying out burning can be obtained.
(2) Necessary and insufficient adhesion is obtained in the condition of humidity of 25 to 60%.
(3) Good alkali development is accomplished without any generation of residues in a proper time. Although the photosensitive layer components are not substantially changed chemically by exposure to light, all of the basic performances of a printing plate such as printing durability, sensitivity and latitude of development can be satisfied. Also, since a high molecular substance having carboxyl group is used, development can be carried if the strength of an alkali developing solution is low. Since development can be carried out at a pH range of developing solution from 10 to 12, the amount of carbonic acid gas dissolved in air is small and a reduction in the pH of an alkali developing solution with time is small that much. On the other hand, a developing solution for phenolic resin is reduced in pH immediately after the preparation of the developing solution by the effect of carbonic acid gas and development cannot be accomplished continuously if a buffer solution is not used as the developing solution. A developing solution that is not a buffer solution will be reduced in alkali concentration in 2 to 3 days at most. In such a situation, the composition is controlled more easily as to a reduction in alkali concentration than a phenolic resin that is developed by a developing solution at a pH of 13.0 or more. Also, the range of selection of the alkali developer is widened and at the same time, waste treatment is easy because the strength of an alkali waste solution is low. The preparation of the developing solution: means that an undiluted solution of a developing solution is diluted with water in a developing tank to form a developing solution.)
(4) Even if image exposure is carried out using an exposure energy lower than high exposure energy causing the generation of excess heat due to a photo-thermal conversion material in the photosensitive layer, a wide latitude of development can be adopted. Therefore, because the generation of scattering of the photosensitive layer is limited to a low level, the problem that the photosensitive layer is scattered (made abrasion) to contaminate the optical system of an exposure apparatus does not arise.
(5) No burning treatment is carried out, which ensures that high sensitivity is maintained and makes it possible to attain such good development that the edge of a resist image has an outline cut sharply in accordance with the exposure irradiated pattern. Also, with regard to the end surface part, a uniform film thickness after development can be maintained as there is no dispersion of heat capacity caused by burning.
(6) A resist image is decreased in a reduction in film thickness and is glossy; pinholes are not produced even if the layer is just etched and gravure-plate- making can be accomplished. Also, a resist image is obtained which has printing durability ensuring that several thousand sheets can be copied if it is subjected to, for example, printing, and the generation of pinholes in the handling before development after the photosensitive film is dried can be avoided or scratching resistance is improved.
(7) A variation in image printing by a laser is reduced and latitude of development is superior.
(8) A reduction in film thickness after development is small and therefore the generation of pinholes is decreased.

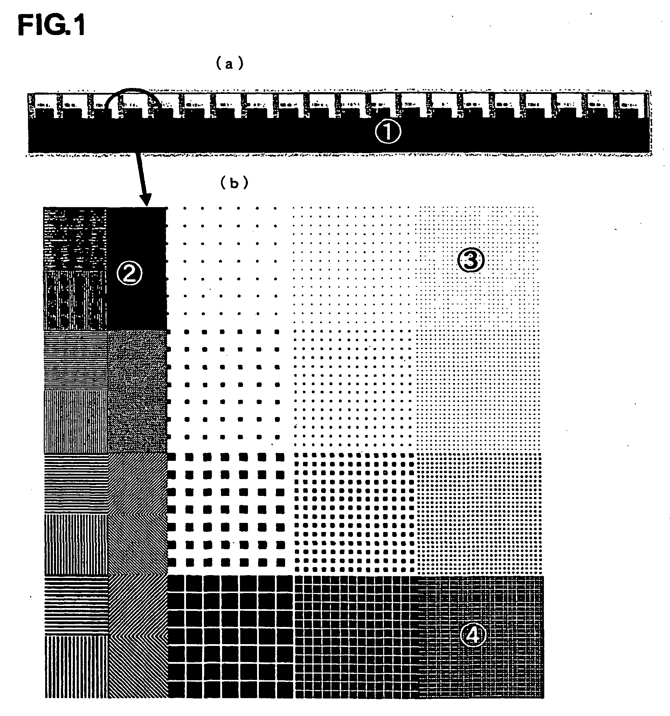

Fig. 1 is a view showing a sensitizing solution test pattern used in Example 1 and measuring positions, where (a) is a test pattern and (b) is an enlarged view of the part marked by a circle in (a).

The positive photosensitive composition of the present invention is a positive photosensitive composition, which does not require heat treatment after the composition is exposed to light, and comprises the following components (A) to (C) as essential components:
(A) an alkali-soluble high molecular substance having in the molecule thereof at least one carboxyl group;
(B) a photo-thermal conversion material which absorbs infrared rays from an image exposure light source to convert the rays to heat;
(C) a thiol compound, and (D) a dissolution inhibitor represented by chemical Formula (2).

As the aforementioned high molecular substance (A), any high molecular substance may be used without any particular limitation insofar as it has at least one carboxyl group in its molecule. Preferable examples of the high molecular substance include a polymer of an unsaturated compound (a1) having at least one carboxyl group and/or at least one carboxylic acid anhydride group and a copolymer of the unsaturated compound (a1) and a compound (a2) copolymerizable with the unsaturated compound. The high molecular substance (A) contains the carboxyl group so as to have an acid value of preferably 30 to 500 and more preferably 180 to 250. The weight average molecular weight of the high molecular substance (A) is preferably 1,500 to 100,000 and more preferably about 3,000 to 10,000.

As the aforementioned unsaturated compound (a1), maleic acid, (meth)acrylic acid, fumaric acid and itaconic acid, and their derivatives are preferable. These compounds may be used either singly or in combinations of two or more.

Preferable examples of the aforementioned maleic acid and its derivative (referred to as a maleic acid monomer) include maleic acid, maleic anhydride, maleic monoester (e.g., monomethyl maleate, monoethyl maleate, mono-*n*-propyl maleate, mono-isopropyl maleate, mono-*n*-butyl maleate, mono-isobutyl maleate and mono-*tert*-butyl maleate) and maleic diester.

Preferable examples of the aforementioned (meth)acrylic acid and its derivative (referred to as a (meth)acryl monomer) include (meth)acrylic acid and (meth)acrylic ester (e.g., methyl (meth)acrylate, ethyl (meth)acrylate, butyl (meth)acrylate and hydroxyethyl (meth)acrylate).

As the compound (a2) copolymerizable with the unsaturated compound (a1), compounds having an unsaturated double bond are preferable and styrene and its derivatives (referred to as styrene monomer) such as styrene, α-methylstyrene, *m-* or *p*-methoxystyrene, *p*-methylstyrene, *p*-hydroxystyrene, 3-hydroxymethyl-4-hydroxy-styrene are particularly preferable. These compounds may be used either singly or in combinations of two or more.

As the aforementioned high molecular substance (A), a polymer of the aforementioned maleic acid monomer, a copolymer of the maleic acid monomer used as major components, a polymer of the aforementioned (meth)acryl monomer, a copolymer of the (meth)acryl monomer used as major components, a copolymer of the maleic acid monomer, the (meth)acryl monomer and other monomer such as the styrene monomer, a styrene/maleic acid copolymer (hereinafter referred to as a copolymer (b1)) obtained by copolymerizing the maleic acid monomer with the styrene monomer, a copolymer of the (meth)acryl monomer and the styrene monomer, derivatives of these polymers or modifications of these polymers are preferable, maleic acid polymer, (meth)acrylic acid polymer, a copolymer having a structure represented by the following general formula (3) and/or the general formula (4) and a structure represented by the following general formula (5) or a copolymer of (meth)acrylic acid, (meth)acrylic acid ester and the styrene monomer are more preferable and copolymers represented by the following general formula (1) are further more preferable.

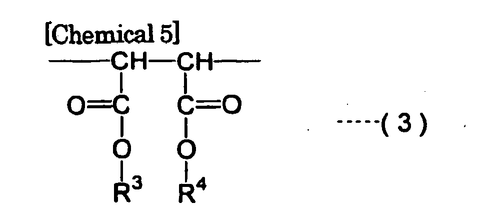

In the formula (3), "R³" and "R⁴" each independently represent a hydrogen atom or a monovalent substituent, preferably a hydrogen atom, a lower alkyl group or a group having a reactive double bond.

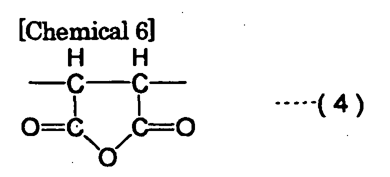

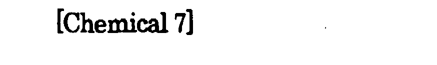

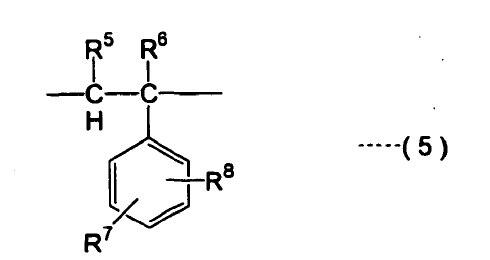

In the formula (5), "R⁵" and "R⁶" each independently represent a hydrogen atom or a monovalent substituent, preferably a hydrogen atom or a methyl group. "R⁷" represents a hydrogen atom or a monovalent substituent, preferably a hydrogen atom, a hydroxyl group, an alkyl group or an alkoxy group, "R⁸" represents a hydrogen atom or a monovalent substituent, preferably a hydrogen atom or a hydroxyalkyl group.

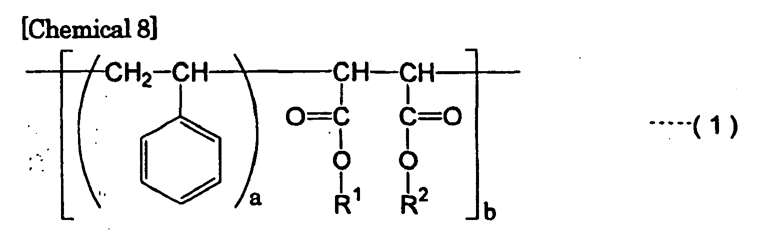

In the formula (1), "R¹" and "R²" are each independently a hydrogen atom or a monovalent substituent, preferably a hydrogen atom or a substituted or unsubstituted alkyl group, more preferably a hydrogen atom or a lower alkyl or alkoxyalkyl group. When a plurality of "R¹" and "R²" are present, they may be the same or different. At least one of "R¹" and "R²" is preferably a hydrogen atom, "a" is 0 or an integer of 1 or more, preferably from 1 to 3, and "b" is an integer of 1 or more, preferably from 6 to 8.

The method for producing the high molecular substance (A) is not particularly limited, and may be performed in accordance with a known method. It is preferable to react a high molecular substance having a carboxylic acid anhydride group with a compound having a hydroxyl group, thereby producing an alkali-soluble high molecular substance having a carboxyl group. For example, the above-mentioned styrene/maleic acid copolymer is preferably obtained by reacting a compound having a hydroxyl group with a styrene/maleic anhydride copolymer (that is, a copolymer of the styrene monomer and maleic anhydride) and thus esterifying the styrene/maleic anhydride copolymer.

Examples of the compound having a hydroxyl group include, though not particularly limited to, alcohols such as isopropanol, *n*-propanol, isopropanol/cyclohexanol, butyl alcohol, isooctanol and ethylene glycol, ethylene glycol ethers such as ethylene glycol butyl ether, and diethylene glycol ethers such as diethylene glycol ethyl ether.

Also, as the aforementioned high molecular substance (A), compounds (hereinafter referred to as a copolymer (b2)) obtained by modifying the aforementioned copolymer (b1) by using a compound having a reactive double bond may be used. In this case, the ratio of the structure represented by the formulae (3) and (4) to the structure represented by the formula (5) is preferably about 1. Specifically, it is possible to produce the above copolymer (b2) by reacting an acid hydride group or carboxyl group in the copolymer (b1) with the compound having a reactive double bond. In this case, it is necessary that a carboxyl group necessary to carry out alkali development be left in the copolymer.

As the compound having a reactive double bond, a compound having a carbon-carbon double bond is preferable. Preferable examples of the compound having a reactive double bond include an unsaturated alcohol (e.g., allyl alcohol, 2-butene-1-2-ol, furfuryl alcohol, oleyl alcohol, cinnamyl alcohol, 2-hydroxyethyl acrylate, hydroxyethyl methacrylate and N-methylol acryl- amide), alkyl (meth)acrylate (e.g., methyl methacrylate and t-butyl methacrylate), an epoxy compound having one oxirane ring and one reactive double bond (e.g., glycidyl acrylate, glycidyl methacrylate, allyl glycidyl ether, α-ethylglycidyl acrylate, crotonyl glycidyl ether and itaconic acid monoalkyl monoglycidyl ester).

As the above copolymer (b2), a compound may be used which is obtained by reacting a compound into which a reactive double bond is introduced by an unsaturated alcohol, with the above epoxy compound having one oxirane ring and one reactive double bond, to thereby increase the concentration of a reactive double bond.

No particular limitation is imposed on a method for producing the above copolymer (b1) or (b2) and the method may be carried out according to a known method (see, for example, Patent documents 5 to 7). A reactive double bond may be introduced also into the high molecular substance having a carboxyl group, other than a styrene/maleic acid polymer in the same manner as above. The imparting of a reactive double bond to the high molecular substance is preferable from the viewpoint of raising hardness and improving printing durability.

There is no particular limitation to the content of the high molecular substance (A) in the positive photosensitive composition of the present invention. However, the content is preferably 80 to 99% by weight and more preferably 90 to 95% by weight based on the total solid amount of the positive photosensitive composition. The high molecular substance (A) may be used either singly or in combinations of two or more.

As the above photo-thermal conversion material (B), any material may be used insofar as it is a compound capable of converting absorbed light into heat. Examples of the photo-thermal conversion material (B) include organic or inorganic pigments and dyes, organic coloring matter, metals, metal oxides, metal carbonates and metal borates, which have an absorption band in a part or all of the infrared region of wavelength of 700 to 1,100 nm. A preferable example of the photo-thermal conversion material (B) is a light- absorbing dye that efficiently absorbs light having the above wavelength range and does not almost absorb light in the ultraviolet region or does not substantially sensitized by the light if it absorbs the light. A Compound represented by the following formula (6) or (7) and their derivatives are preferably used.

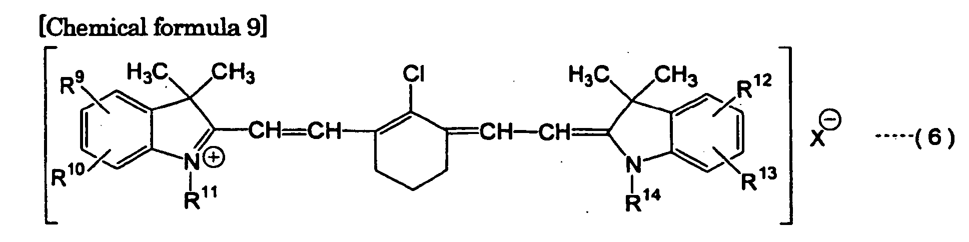

In the formula (6), "R⁹" to "R¹⁴" each independently represent a hydrogen atom, an alkyl group having 1 to 3 carbon atoms, or an alkoxy group having 1 to 3 carbon atoms, and "X" represents a counter anion and examples of "X" include halogen atoms, ClO₄, BF₄, p-CH₃C₆H₄SO₃, and PF₆.

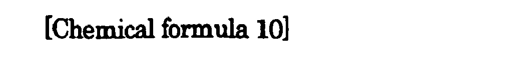

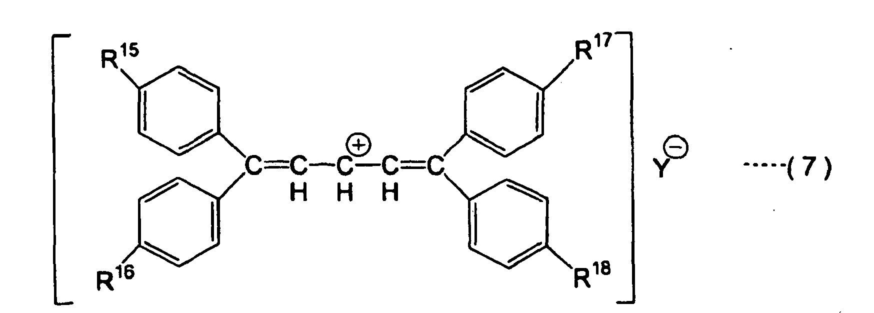

In the formula (7), "R¹⁵" to "R¹⁸" each independently represent a hydrogen atom, a methoxy group, -N(CH₃)₂, or -N(C₂H₅)₂, and "Y" represents a counter anion and examples of "Y" include C₄H₉-B(C₆H₅)₃, p-CH₃C₆H₄SO₃, and CF₃SO₃.

More preferable examples of the compound represented by the general formula (7) include near infrared absorbing colorants which are represented by the following chemical formulae (8) to (11) and have a maximum absorption wavelength in a near infrared range.

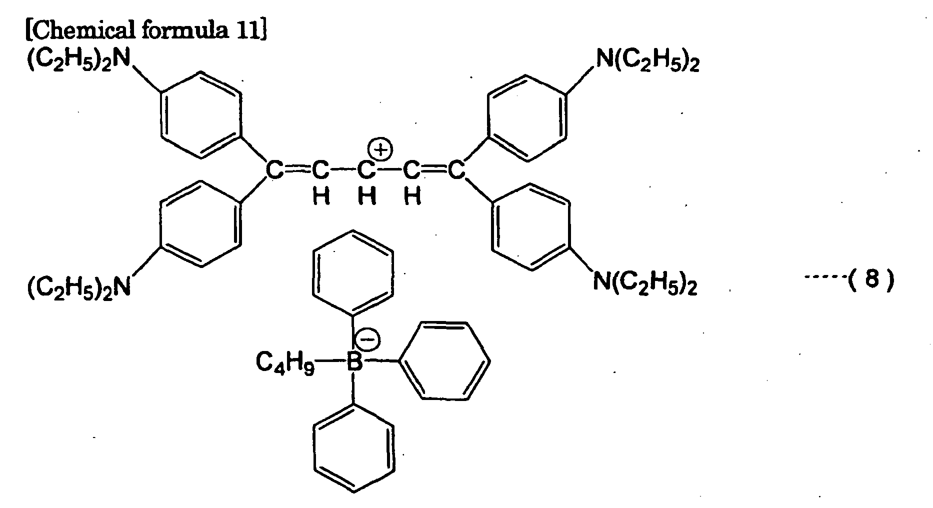

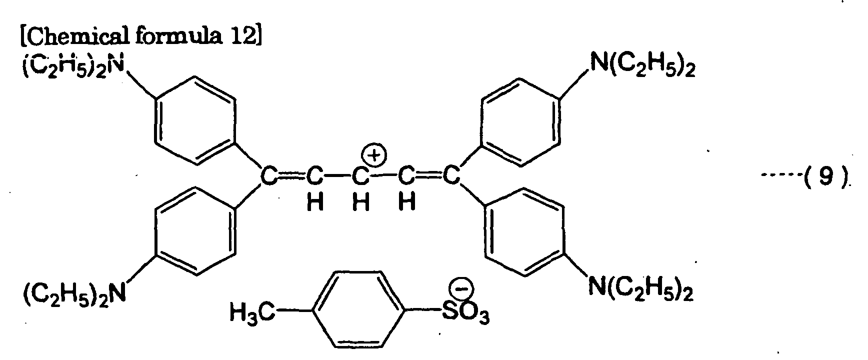

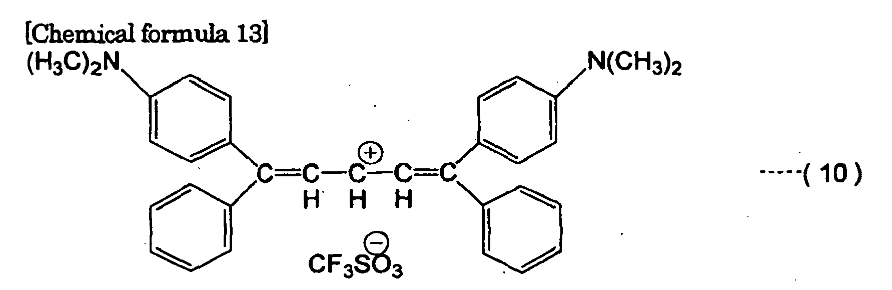

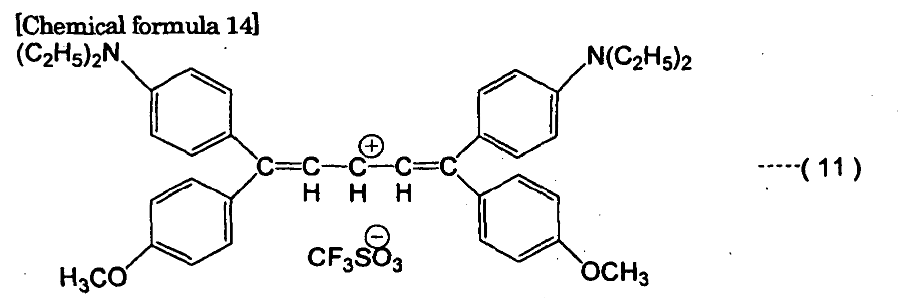

Also, examples of other light-absorbing dyes include cyanine dyes so-called in a wide sense which have the structure in which a heterocyclic ring containing a nitrogen atom, an oxygen atom or a sulfur atom are combined by a polymethine (-CH=)ₙ as described in Patent document 6. Specific examples of these cyanine dyes include a quinoline type (so-called cyanine type), indole type (so-called indocyanine type), benzothiazole type (so-called thiocyanine type), iminocyclohexadiene type (so-called poly- methine type), pyrylium type, thiapyrylium type, squarylium type, croconium type and azulenium type. Among these types, a quinoline type, indole type, benzothiazole type, iminocyclohexadiene type, pyrylium type or thiapyrylium type is preferable. Particularly, phthalocyanine or cyanine is preferable.

The aforementioned photo-thermal conversion material (B) has an absorption band in a part or all of the infrared region of a wavelength of 700 to 1,100 nm, has the characteristics that it absorbs laser light of the infrared wavelength region to be heat-decomposed, and participates in molecular reduction/abrasion relative to alkali solubility which is caused by thermal cutting of a molecule of the high molecular substance (A) having a carboxyl group.

The quantity of the photo-thermal conversion material to be added relates to whether heat generated in exposure is excessive or insufficient and also, the intensity of the infrared laser relates to whether the heat decomposition of organic high molecular substance existing in the exposed portion is excessive or insufficient. Therefore, the amount of the photo- thermal conversion material is designed to be an appropriate amount. The content of the photo-thermal conversion material (B) in the positive photo- sensitive composition of the present invention is preferably 0.1 to 10% by weight and more preferably 1 to 4% by weight based on the total solid amount of the positive photo- sensitive composition.

The thiol compound (C) is not particularly limited insofar as it is a compound having a SH group. Examples thereof include mercaptans such as 2-mercaptoethanol, thiomalic acid, tritylmercaptan, 4-aminothiophenol and methyl 3-mercaptopropionate, thiocarboxylic acids such as thioacetic acid, thiadiazoles such as 2,5-dimercapto-1,3,4-thiadiazole and 2-thioacetic acid-5-mercapto-1,3,4-thiadiazole, pentaerythritol tetrakisthioglycolate, 1-(2-dimethylaminoethyl)-5-mercapto-1H-tetrazole, 2,4,6-trimercapto-s-triazine, 2-dibutylamino-4,6-dimercapto-s-triazine, a mono sodium salt of 2,4,6-trimercapto-s-triazine, 2-amino-4,6-dimercapto-s-triazine, p-mercaptophenol, and a compound represented by the following general formula (12) (this has a tautomeric relationship with the following general formula (13)):

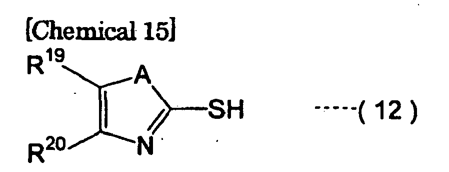

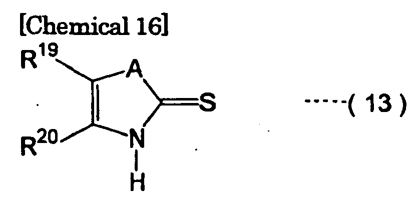

In the formulae (12) and (13), "A" represents a sulfur atom, an oxygen atom or >N-R²¹; "R²¹" represents a hydrogen atom or an alkyl group having 1 to 5 carbon atoms; "R¹⁹" and "R²⁰" are each, a hydrogen atom, an alkyl group having 1 to 5 carbon atoms, a hydroxyalkyl group having 1 to 3 carbon atoms, a phenyl group which may be substituted with an alkyl or alkoxy group having 1 to 8 carbon atoms, a nitro group, an alkoxycarbonyl group having an alkyl group having 1 to 8 carbon atoms, a phenoxycarbonyl group, an acetyl group, or a carboxyl group; "R¹⁹", "R²⁰" and the double bond through which these are bonded may be combined together to form a benzene ring; and the double bond through which "R¹⁹" and "R²⁰" are bonded may be hydrogenated.

Specific examples of the thiol compounds represented by the formula (12) include the following:
(1) 2-mercaptobenzoimidazole 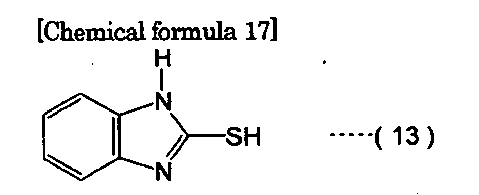
(2) 2-mercaptobenzooxazole 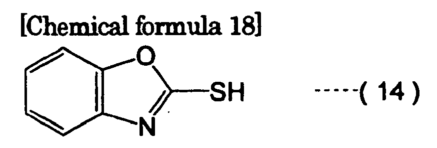
(3) 2-mercaptobenzothiazole 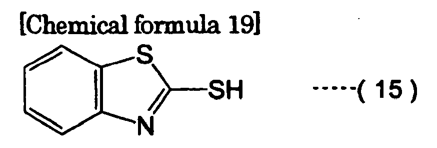
(4) 1-methyl-2-mercaptobenzoimidazole 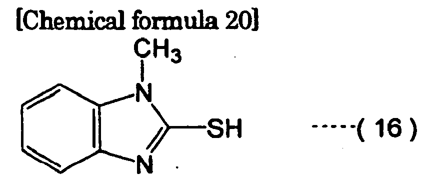
(5) 2-mercapto-4-methyl-5-acetylthiazole 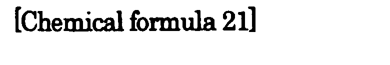 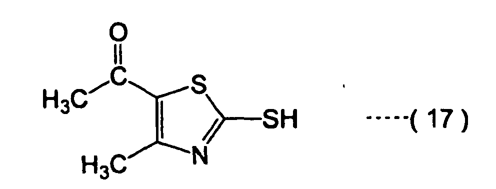
(6) 2-mercapto-5-acetylthiazole 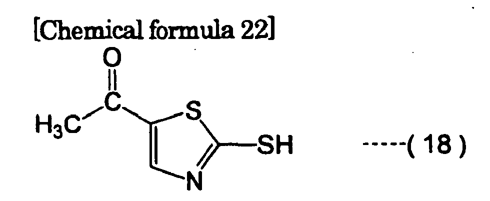
(7) 1-methyl-2-mercapto-4-methyl-5-acetylimidazole 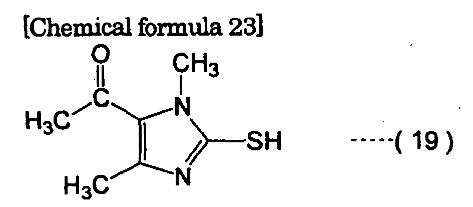
(8) 1-methyl-2-mercaptoimidazole 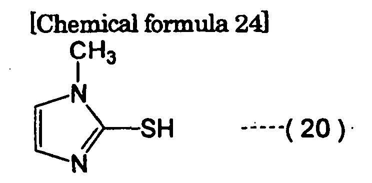
(9) 2-mercaptooxazole 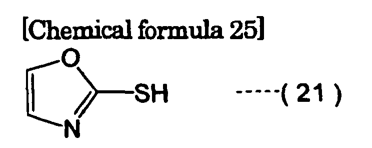
(10) 2-mercapto-4-methylthiazole 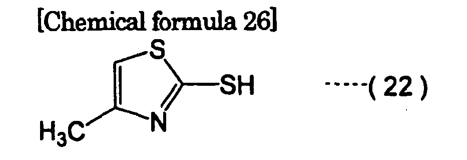
(11) 2-mercapto-4,5-dimethylthiazole 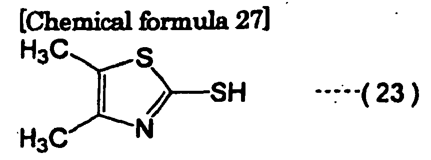
(12) 2-mercapto-2-imidazoline

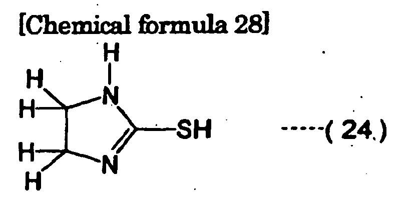

These thiol compounds may be used alone or in combination of two or more thereof. The content by percentage of the thiol compound (C) in the positive photosensitive composition of the present invention is preferably from 0.1 to 10% by weight of the total of solids in the positive photosensitive composition, more preferably from 0.2 to 5% by weight thereof.

A dissolution inhibitor (D) is incorporated into the positive photosensitive composition of the present invention. The aforementioned dissolution inhibitor (D) is compounded for the purpose of increasing a time difference of solubility in an alkali developing solution between an exposed portion and an unexposed portion. As the dissolution inhibitor (D), a compound is used which has the ability of forming a hydrogen bond together with the high molecular substance (A) to reduce the solubility of the high molecular substance, does not almost absorb light in the infrared region and is not decomposed by light in the infrared region.

As the dissolution inhibitor (D), there is used a compound represented by the following formula (2) (4,4'-[1-[4-[1-(4-hydroxyphenyl)-1-methylethyl]phenyl]ethylidene]bisphenol).

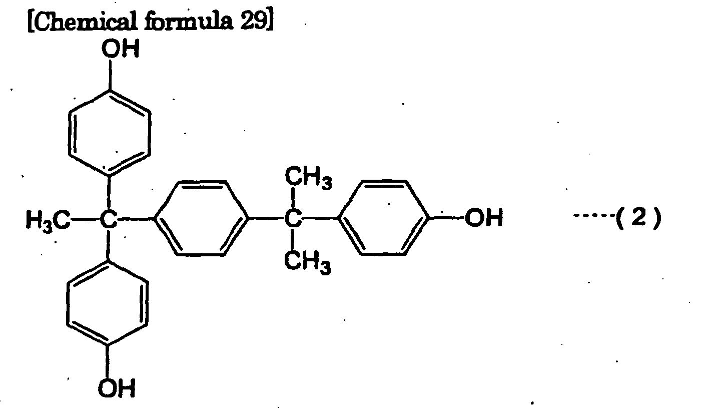

The content of the dissolution inhibitor (D) in the positive photo- sensitive composition of the present invention is preferably 0.5 to 8% by weight and more preferably 1 to 5% by weight based on the total solid amount of the positive photosensitive composition. These dissolution inhibitors may be used either singly or in combinations of two or more.

The positive photosensitive composition of the present invention may comprise, besides the above-mentioned components, if necessary, various additives such as an adhesion-modifying agent, a photo sensitizer, coloring agents such as pigments or dyes, a development promoter, and a coating improving agent.

The adhesion-modifying agent is not particularly limited, and there may be preferably used an alkali-soluble resin such as a vinylpyrrolidone/vinyl acetate copolymer, a vinylpyrrolidone/dimethylaminoethyl methacrylate copolymer, a vinylpyrrolidone/vinylcaprolactam/dimethylaminoethyl methacrylate copolymer, polyvinyl acetate, polyvinyl butyral, polyvinyl formal, a terpene phenol resin, an alkylphenol resin, a melamine/formaldehyde resin, and a ketone resin. These adhesion-modifying agents may be used alone or in combination of two or more thereof.

The coloring agent is in particular preferably a triarylmethane dye. As the triarylmethane dye, triarylmethane dyes known in the prior art can be variously used. Specifically, there may be preferable methyl violet, crystal violet, Victoria Blue B, Oil Blue 613(a trade name of a product manufactured by Orient Chemical Industries, Ltd.), and derivatives thereof. These triarylmethane dyes can be used alone or in combination of two or more thereof.

The use of the coloring dyes produces an effect that pinholes, dust or the like on the surface of the photosensitive film can be clearly recognized at the time of forming a pattern therein by development, so that a stopping out operation with a retouching solution (opaque) is easily conducted. As the concentration of the dye is higher, the pinholes or the like are more easily recognized, which is preferred. In the semiconductor industry, retouching cannot be conducted; thus, semiconductors are produced in clean rooms. However, in the printing industry and the industry related to electronic parts, retouching is conducted to reproduce inferior goods.

As to the above-mentioned development promoter, it is preferable to add, for example, a dicarboxylic acid, an amine compound or a glycol compound in a very small amount. As the above-mentioned photo sensitizer, there is preferably a compound which generates an acid by action of light or heat. Examples of the photo sensitizer include diphenyliodonium salts, triphenylsulfonium salts, aromaticsulfonic acid esters, triazine compounds, and diazodisulfone compounds. A compound represented by the following formula (25) is particularly preferable.

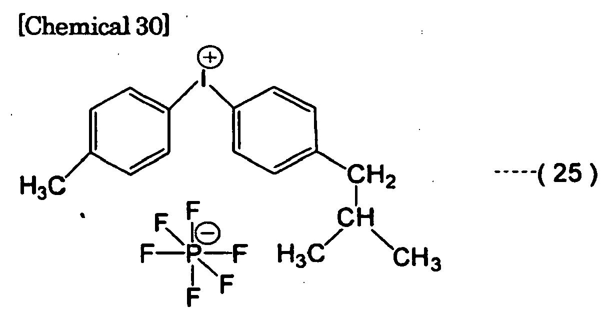

The positive photosensitive composition of the present invention is usually used in the form of a solution obtained by dissolving the composition in a solvent. The proportion by weight of the solvent to be used is generally in a range from 1 to 20 times the total solid content of the photosensitive composition.

As the solvent, any solvent may be used without any particular limitation insofar as it has enough solubility to components used and imparts good coatability, and a cellosolve type solvent, propylene glycol type solvent, ester type solvent, alcohol type solvent, ketone type solvent or highly polar solvent may be used. Examples of the cellosolve type solvent include methyl cellosolve, ethyl cellosolve, methyl cellosolve acetate and ethyl cellosolve acetate. Examples of the propylene glycol type solvent include propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether. Examples of the ester type solvent include butyl acetate, amyl acetate, ethyl butyrate, butyl butyrate, diethyl oxalate, ethyl pyruvate, ethyl-2-hydroxybutyrate, ethyl acetoacetate, methyl lactate, ethyl lactate and methyl-3-methoxy- propionate. Examples of the alcohol type solvent include heptanol, hexanol, diacetone alcohol and furfuryl alcohol. Examples of the highly polar solvent include ketone type solvents such as cyclohexanone and methyl amyl ketone, dimethylformamide, dimethylacetamide and N-methyl-pyrrolidone. Examples other than the above include acetic acid, mixtures of these solvents, and, further, solvents obtained by adding an aromatic hydrocarbon to these solvents.

The positive photosensitive composition of the present invention may be produced in the following manner. Usually, the above each component is dissolved in a solvent such as a cellosolve type solvent or propylene glycol type solvent to make a solution, which is then applied to the surface of the support, specifically, the copper or copper sulfate plating surface of the plate- making roll for gravure printing use and naturally dried. Then, the roll is rotated at high speed so that the surface of the plate-making roll goes through the air. A mass effect due to centrifugal force in the photosensitive film and the condition of the neighborhood of the surface placed under a slightly negative pressure allow the concentration of residual solvents to be reduced to 6% or less, to thereby make a positive photosensitive film with the photo- sensitive composition layer being formed on the surface of the support.

As a coating method, meniscus coating, fountain coating, dip coating, rotary coating, roll coating, wire bar coating, air-knife coating, blade coating and curtain coating may be used. The thickness of the coating film is in a range preferably from 1 to 6 µm and more preferably 3 to 5 µm.

As the light source used for image exposure of the positive photo- sensitive composition layer, a semiconductor laser and a YAG laser which emit infrared laser rays having a wavelength of 700 to 1,100 nm are preferable. Besides the above, a solid laser such as a ruby laser and LED may be used. The intensity of the laser light source is designed to be 50 to 700 mJ/scm² and particularly preferably 80 to 250 mJ/scm².

As a developing solution used for the photosensitive film formed by using the positive photosensitive composition of the present invention, a developing solution comprising an inorganic alkali (e.g., salts of Na or K) or an organic alkali (e.g., TMAH (Tetra Methyl Ammonium Hydroxide) or choline) is preferable.

The development is carried out at usually about 15 to 45°C and preferably 22 to 32°C by dipping development, spray development, brush development, ultrasonic development and so on.

### Examples

### (Example 1)

The ingredients and proportions shown in Table 1 were used to prepare a positive photosensitive composition. This was used as a test photosensitive solution.

**[Table 1]**

| Ingredients | | Proportion (parts by weight) |
|---|---|---|
| Component (A): Resin 1 | | 100 |
| Component (B): IR-photosensitive dye 1 | | 3 |
| Component (C): Thiol 1 | | 1 |
| Component (D): Dissolution inhibitor | | 2 |
| Color dye | | 2 |
| Solvent | PM | 590 |
| | IPA | 737 |
| | MEK | 589 |

Each component in Table 1 is as follows:
Resin 1: SMA^{®} 1440 (a partial ester of styrene/maleic anhydride copolymer with butylcellosolve, manufactured by SARTOMER Company, Inc.)
IR-photosensitive dye 1: Infrared absorbing dye represented by the formula (6)
Thiol 1:2-mercaptobenzooxazole
Dissolution inhibitor : Tris P-PA (compound represented by the formula (2), manufactured by Honshu Chemical Industry Co., Ltd.)
Color dye : Oil Blue 613 (Color Index (C.I.) No. 42595, manufactured by Orient Chemical Industries, Ltd.)
PM: Ppropylene glycol monomethyl ether
IPA: Isoproyl alcohol
MEK: Methyl ethyl ketone

The following experiments were made using the obtained test sensitizing solutions. The experiment was carried out under the condition that laboratory was maintained at a temperature of 25°C and the humidity shown in Table 2. A plate-making roll of φ 200 mm which used iron as base material of the roll and was plated with copper sulfate and mirror-polished was rotated at 25 r.p.m. with the both ends thereof being chucked by a fountain coating apparatus (apparatus equipped with a dehumidifier and a humidifier where the humidity can be controlled desirably) and thoroughly wiped and cleaned by a wiping cloth. It is to be noted that the fountain coating apparatus has the ability to avoid the phenomenon that solvents in the positive photosensitive composition are vaporized to change the ratio of these solvents during coating.

Thereafter, a pipe allowing the test sensitizing solution to be overflowed from the top thereof was positioned at one end of the plate-making roll so as to form a gap of about 500 µm from the roll. The pipe was moved from one end to the other end of the roll with making the test sensitizing solution overflow in an amount necessary for coating, to apply the test sensitizing solution uniformly to the roll by a spiral scan method, and the rotation was continued at 25 r.p.m. for 5 minutes after the application was finished and then stopped.

Five minutes were taken for waiting until oozing of a liquid was observed, with the result that the generation of the oozing of a liquid could not be observed with the naked eye. Then, the film thickness was measured, to find that there was no difference in thickness between the lower surface part and upper surface part of the roll. It was thus confirmed that the photosensitive film dried to a solid condition permitting no oozing of a liquid was set.

In succession, the test roll was rotated at 100 r.p.m. for 20 minutes and then stopped to measure the concentration of residual solvents in the photosensitive film, to find that the concentration was 2.9%.

Then, the test roll was fit to an exposure apparatus (manufactured by Think Laboratory) mounted with a high-power semiconductor laser head of CreoScitex Co., Ltd. and then irradiated with laser light having a wavelength falling in the infrared region to print a positive image. Next, the test roll was fit to a developing machine and was developed with rotating the roll and lifting the developing tank until no residue was observed, followed by washing with water. As the developing solution, 4.2% KOH (25°C) was used. The resulting resist image was evaluated by a microscope. The results are shown in Table 2.

**[Table 2]**

| | Humidity (%) | Adhesion | Sensitivity (mJ/cm²) | Development (seconds) | Rate of residual film (%) | Image | Resolution of edges | Latitude of development |
|---|---|---|---|---|---|---|---|---|
| Example 1-1 | 35 | Ⓞ | 220 | 75 | 75 | Good | Good | Ⓞ |
| Example 1-2 | 45 | Ⓞ | 220 | 75 | 73 | Good | Good | Ⓞ |
| Example 1-3 | 55 | Ⓞ | 220 | 75 | 74 | Good | Good | Ⓞ |

The methods of evaluation in Table 2 are as follows.
1) Resolution of edges
   Using the resolution test pattern shown in Fig. 1, whether or not the edges of 7.9 µm line of a check and grating was sharp.
2) Latitude of development
   The latitude of development was measured using a cellar (device capable of automatically measuring the opening ratio of dots) manufactured by Dai Nippon Printing Co., Ltd. A test was made in which the number of developing processes was increased (three times in the Example). In the case where the cell area falls in 60 to 75 µm² by exposure to light of 7.9 µm x 7.9 µm, this cell area falls in the allowable range of printing density and shows that the latitude of development is good, which is expressed as "⊚" in the table. In the case where the cell area is out of the allowable range of printing, the latitude of development is expressed as "x" in the table.
3) Adhesion
   The tesa test: in a cross-cut adhesion test using a DIN EN ISO 2409 tesa tape, the case where 100 squares all remain is defined as "⊚", the case where squares less than 20% are peeled is defined as "○" and the case where 20% or more of squares are peeled is defined as "×".
4) Sensitivity
   Exposure amount was varied to find one at which an image pattern was reproduced most exactly to decide the sensitivity. As the exposure apparatus, a thermal imaging head manufactured by Creo Co., Ltd. was used.
5) Development
   The development time taken until no residue was found was measured.
6) The rate of residual film
   Film thicknesses before and after development were measured using FILMETRICS Thin Film Analyzer F20 (manufactured by Filmetrics Co.) which calculate thickness of coating film to calculate the rate of residual film.
7) Image
   The reproducibility of an original image was evaluated.

The test pattern of the sensitizing solution and measuring positions are shown in Fig. 1. Check items and measuring method for the measuring positions in Fig. 1 are shown in Table 3.

**[Table 3]**

| Measuring position | Checking item | Photography | Measurement of area (Cellzoh) |
|---|---|---|---|
| ① | Presence or absence of developing residue | - | - |
| ② | 1 Pixel check | ○ | - |
| ③ | 1Pixel highlight | ○ | ○ |
| ④ | 7 µm grating | ○ | ○ |

As shown in Table 2, the positive photosensitive composition of Example 1 made it possible to carry out good development to obtain a sharp pattern freed of residues in about 70 seconds in the condition of a room temperature of 25°C and humidity of 35 to 55%. Also, good latitude of development was obtained.

The experiment was also made in the case of using a copper surface or an aluminum surface in place of the copper sulfate plating surface. In all of these cases, the same satisfactory results as in Example 1 were obtained. In the case of the aluminum surface, a especially wide latitude of development was obtained.

### (Examples 2 to12)

The same experiments as in Example 1-2 were made except that the component (C) in the compositions was altered as shown in Table 4. The measurement was made under humidity of 45%. The results are shown in Table 4.

**[Table 4]**

| Example Nos. | Component (C) | Adhesion | Sensitivity (mJ/cm²) | Development (seconds) | Rate of residual film (%) | Image | Resolution of edges | Latitude of development |
|---|---|---|---|---|---|---|---|---|
| 2 | Thiol 2 (2) | Ⓞ | 220 | 75 | 68 | Good | Good | Ⓞ |
| 3 | Thiol 3 (1) | Ⓞ | 220 | 75 | 74 | Good | Good | Ⓞ |
| 4 | Thiol 4 (0.5) | Ⓞ | 220 | 75 | 72 | Good | Good | Ⓞ |
| 5 | Thiol 5 (2) | Ⓞ | 220 | 75 | 70 | Good | Good | Ⓞ |
| 6 | Thiol 6 (3) | Ⓞ | 220 | 75 | 74 | Good | Good | Ⓞ |
| 7 | Thiol 7 (1) | Ⓞ | 220 | 75 | 71 | Good | Good | Ⓞ |
| 8 | Thiol 8 (4) | Ⓞ | 220 | 75 | 76 | Good | Good | Ⓞ |
| 9 | Thiol 9 (0.3) | Ⓞ | 220 | 75 | 75 | Good | Good | Ⓞ |
| 10 | Thiol 10 (1) | Ⓞ | 220 | 75 | 72 | Good | Good | Ⓞ |
| 11 | Thiol 11 (0.2) | Ⓞ | 220 | 75 | 73 | Good | Good | Ⓞ |
| 12 | Thiol 12 (2) | Ⓞ | 220 | 75 | 74 | Good | Good | Ⓞ |

In Table 4, thiols 2 to 12 are described below. The numerical value inside of the parentheses beside each of the thiols represents the proportion thereof, and the proportions are shown by parts by weight when the proportion of the component (A) is to 100 parts by weight.
Thiol 2: 2-mercaptobenzoimidazole
Thiol 3: 2,5-dimercapto-1,3,4-thiadiazol
Thiol 4: 2-thioacetic acid-5-mercapto-1,3,4-thiadiazole
Thiol 5: 2-mercaptoethanol
Thiol 6: thioacetic acid
Thiol 7: 1-(2-dimethylaminoethyl)-5-mercapto-1H-tetrazole
Thiol 8: pentaerythritol tetrakisthioglycolate
Thiol 9: 2,4,6-trimercapto-s-triazine
Thiol 10: 2-amino-4,6-dimercapto-s-triazine
Thiol 11: p-mercaptophenol
Thiol 12: 4-aminothiophenol

### (Examples 13 to 21)

The same experiments as in Example 1-2 were made except that the component (A) in the compositions was altered as shown in Table 5. The results are shown in Table 5.

**[Table 5]**

| Example Nos | Component (A) | Adhesion | Sensitivity (mJ/cm²) | Development (seconds) | Rate of residual film (%) | Image | Resolution of edges | Latitude of development |
|---|---|---|---|---|---|---|---|---|
| 13 | Resin 2 | Ⓞ | 220 | 75 | 75 | Good | Good | Ⓞ |
| 14 | Resin 3 | Ⓞ | 220 | 75 | 78 | Good | Good | Ⓞ |
| 15 | Resin 4 | Ⓞ | 220 | 75 | 72 | Good | Good | Ⓞ |
| 16 | Resin 5 | Ⓞ | 220 | 75 | 78 | Good | Good | Ⓞ |
| 17 | Resin 6 | Ⓞ | 220 | 75 | 77 | Good | Good | Ⓞ |
| 18 | Resin 7 | Ⓞ | 220 | 75 | 72 | Good | Good | Ⓞ |
| 19 | Resin 8 | Ⓞ | 220 | 75 | 79 | Good | Good | Ⓞ |
| 20 | Resin 9 | Ⓞ | 220 | 75 | 71 | Good | Good | Ⓞ |
| 21 | Resin 10 | Ⓞ | 220 | 75 | 73 | Good | Good | Ⓞ |

In Table 5, the proportion of the component (A) was the same as in Example 1, and resins 2 to 10 were as follows.
Resin 2: SMA^{®} 17352 (partially esterified product of a styrene/maleic anhydride copolymer with isopropanol/cyclohexanol, manufactured by Sartomer Company, Inc)
Resin 3: SMA^{®} 2624 (partially esterified product of a styrene/maleic anhydride copolymer with n-propanol, manufactured by Sartomer Company, Inc.)
Resin 4: SMA^{®} 3840 (partially esterified product of a styrene/maleic anhydride copolymer with isooctanol, manufactured by Sartomer Company, Inc.)
Resin 5: OXYLAC^{®} SH-101 (copolymer of styrene/maleic acid half-ester, manufactured by Nippon Shokubai Co., Ltd.)
Resin 6: copolymer of acrylic acid, methyl methacrylate, and styrene (acid value: 98, weight-average molecular weight: 21000, and base monomer ratio: acrylic acid/methyl methacrylate/styrene = 1:1:1)
Resin 7: maleic acid polymer (acid value: 300, and weight-average molecular weight: 10000)
Resin 8: acrylic acid polymer (acid value: 100, and weight-average molecular weight: 25000)
Resin 9: OXYLAC^{®} SH-101 derivative (styrene/maleic acid copolymer to which glycidyl methacrylate is added, acid value: 80)
Resin 10: Resin 6 to which glycidyl-methacarylate is added.

### (Examples 22 to 26)

The same experiments as in Example 1-2 were made except that the component (B) in the compositions was altered as shown in Table 6. The results are shown in Table 6.

**[Table6]**

| Example Nos | Component (B) | Adhesion | Sensitivity (mJ/cm²) | Development (seconds) | Rate of residual film (%) | Image | Resolution of edges | Latitude of development |
|---|---|---|---|---|---|---|---|---|
| 22 | Dye 2(1) | Ⓞ | 220 | 75 | 75 | Good | Good | Ⓞ |
| 23 | Dye 3(3) | Ⓞ | 220 | 75 | 76 | Good | Good | Ⓞ |
| 24 | Dye 4(4) | Ⓞ | 220 | 75 | 73 | Good | Good | Ⓞ |
| 25 | Dte 5(6) | Ⓞ | 220 | 75 | 72 | Good | Good | Ⓞ |
| 26 | Dye 6(2) | Ⓞ | 220 | 75 | 75 | Good | Good | Ⓞ |

In Table 6, the dyes 2 to 6 are as follows. The numerical value inside of the parentheses beside each of the dyes represents the proportion thereof, and the proportions are shown by parts by weight when the proportion of the component (A) is to 100 parts by weight.
Dye 2: IR-B (infrared absorbing dye represented by the above formula (8), manufactured by Showa Denko K K)
Dye 3: IR-T (infrared absorbing dye represented by the above formula (9), manufactured by Showa Denko K K)
Dye 4: IR-2MF (infrared absorbing dye represented by the above formula (10), manufactured by Showa Denko K. K.)
Dye 5: IR-13F (infrared absorbing dye represented by the above formula (11), manufactured by Showa Denko K. K.)
Dye 6: NK-2014 (infrared absorbing colorant represented by the formula (26), manufactured by Hayashibara Biochemical Labs., Ltd.)

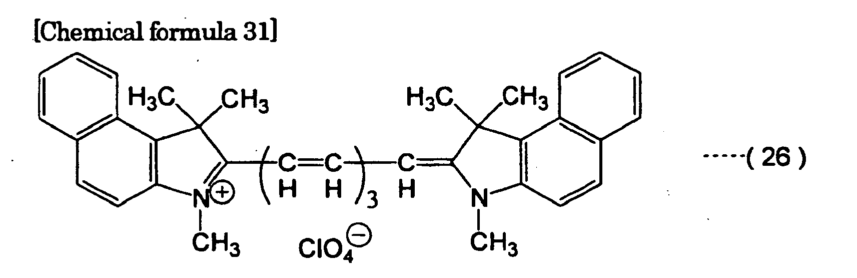

### (Comparative Example 1)

An experiment was made in the same way as in Example 1-2 except that a composition into which a novolak resin [PR-NMD-100 (manufactured by Sumitomo Bakelite Co., Ltd.)] was incorporated instead of the resin 1 was used as a test photosensitive solution. The coated film of Comparative Example 1 was entirely flowed by an alkaline developing solution. After the development, no image was formed.

### Capability of Exploitation in Industry:

The positive photosensitive composition of the present invention is preferably used to form a positive photosensitive film on the copper sulfate surface of a plate-making roll for gravure printing. However, no particular limitation to the material on which the composition of the present invention is applied. Even if the composition is applied to plates of metals such as aluminum, zinc and steel, metal plates on which aluminum, zinc, copper, iron, chromium, nickel, or the like is plated or deposited, paper coated with a resin, paper coated with a metal foil such as an aluminum foil, plastic films, hydrophilically treated plastic films, glass plates, and so on, it has high adhesion at low temperatures, ensuring that high sensitivity is obtained.

The positive photosensitive composition of the present invention is, therefore, preferably used for photosensitive planographic printing plates, proofs for simplified proofing printing, wiring boards, gravure copper etching resists, color-filter resists used to produce flat displays, photoresists for producing LSI, a member related for forgery prevention and the like.

## Claims

1. A positive photosensitive composition, which does not require heat treatment after the composition is coated, comprising:
(A) an alkali-soluble high molecular substance having in the molecule thereof at least one carboxyl group;
(B) a photo-thermal conversion material which absorbs infrared rays from an image exposure light source to convert the rays to heat;
(C) a thiol compound; and
(D) a dissolution inhibitor, **characterized in that** the dissolution inhibitor is a compound represented by the following chemical formula (2):

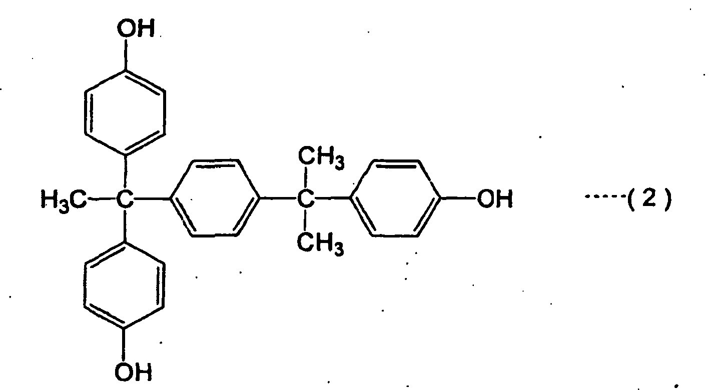

2. The positive photosensitive composition according to claim 1, wherein the high molecular substance (A) is at least one polymer selected from the group consisting of a polymer obtained from an unsaturated compound (a1) having at least one carboxyl group and/or carboxylic acid anhydride group and a copolymer obtained from the unsaturated compound (a1) and a compound (a2) copolymerizable with the unsaturated compound.

3. The positive photosensitive composition according to claim 2, wherein the unsaturated compound (a1) is at least one compound selected from the group consisting of maleic acid, (meth)acrylic acid, and their derivatives.

4. The positive photosensitive composition according to any one of claims 1 to 3, wherein the high molecular substance (A) is at least one polymer selected from the group consisting of a maleic acid polymer, a (meth)acrylic acid polymer, a styrene/maleic acid copolymer and their derivatives.

5. The positive photosensitive composition according to any one of claims 1 to 4, wherein the high molecular substance (A) is a reactant of a high molecular substance having a carboxylic acid anhydride group and a compound having a hydroxyl group.

6. The positive photosensitive composition according to claim 4 or 5, wherein the high molecular substance (A) is a styrene/maleic acid copolymer obtained by reacting a styrene/maleic anhydride copolymer with a compound having a hydroxyl group.

7. The positive photosensitive composition according to any one of claims 1 to 6, wherein the high molecular substance (A) is a polymer represented by the following general formula (1): 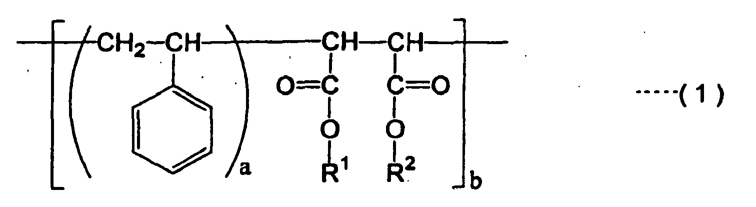 wherein R¹ and R² each independently represent a hydrogen atom or a substituted or unsubstituted alkyl group, "a" is an integer of 1 to 3 and b is an integer of 6 to 8.

8. The positive photosensitive composition according to claim 5 or 6, wherein the compound having a hydroxyl group is an alcohol.

9. The positive photosensitive composition according to any one of claims 1 to 8, wherein the thiol compound (C) is 2-mercaptobenzooxazol.

10. A photo-fabrication method, comprising the use of the positive photosensitive composition according to any one of claims 1 to 9.

11. The photo-fabrication method according to claim 10, which is applied to production of a printing plate, an electronic component, a precision equipment component or a component relating to a counterfeit deterrence.

12. A plate-making method, comprising the use of the positive photosensitive composition according to any one of claims 1 to 9.

## Patentansprüche

1. Positive lichtempfindliche Zusammensetzung, die keine Hitzebehandlung benötigt nachdem die Zusammensetzung aufgetragen wurde, umfassend:
(A) eine alkalilösliche hochmolekulare Substanz mit mindestens einer Carboxylgruppe im Molekül;
(B) ein photothermisches Umwandlungsmaterial, das Infrarotstrahlen von einer Lichtquelle zur Bildbelichtung absorbiert und die Strahlen in Wärme umwandelt;
(C) eine Thiolverbindung; und
(D) einen Auflösungshemmer, **dadurch gekennzeichnet dass** der Auflösungshemmer eine Verbindung, dargestellt durch die folgende chemische Formel (2), ist:

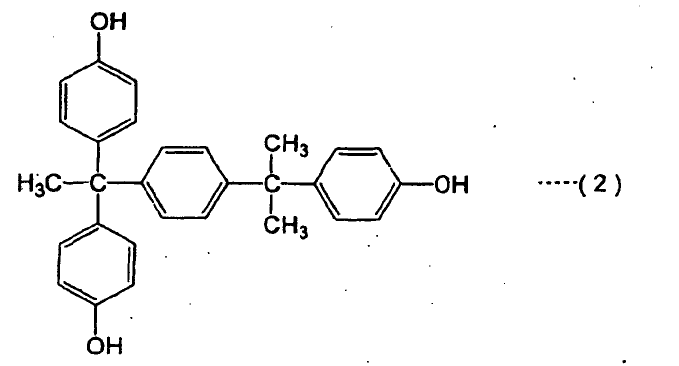

2. Positive lichtempfindliche Zusammensetzung nach Anspruch 1, worin die hochmolekulare Substanz (A) mindestens ein Polymer ist, ausgewählt aus der Gruppe bestehend aus einem Polymer, erhalten aus einer ungesättigten Verbindung (a1) mit mindestens einer Carboxylgruppe und/oder Carbonsäureanhydridgruppe, und einem Copolymer, erhalten aus der ungesättigten Verbindung (a1) und einer Verbindung (a2), die mit der ungesättigten Verbindung copolymerisierbar ist.

3. Positive lichtempfindliche Zusammensetzung nach Anspruch 2, worin die ungesättigte Verbindung (a1) mindestens eine Verbindung, ausgewählt aus der Gruppe bestehend aus Maleinsäure, (Meth)Acrylsäure und deren Derivaten, ist.

4. Positive lichtempfindliche Zusammensetzung nach einem der Ansprüche 1 bis 3, worin die hochmolekulare Substanz (A) mindestens ein Polymer, ausgewählt aus der Gruppe bestehend aus einem Maleinsäurepolymer, einem (Meth)Acrylsäurepolymer, einem Styrol/Maleinsäure-Copolymer und deren Derivaten, ist.

5. Positive lichtempfindliche Zusammensetzung nach einem der Ansprüche 1 bis 4, worin die hochmolekulare Substanz (A) ein Reaktant einer hochmolekularen Substanz mit einer Carbonsäureanhydridgruppe und einer Verbindung mit einer Hydroxylgruppe ist.

6. Positive lichtempfindliche Zusammensetzung nach Anspruch 4 oder 5, worin die hochmolekulare Substanz (A) ein Styrol/Maleinsäure-Copolymer, erhalten durch Umsetzen von Styrol/Maleinsäureanhydrid-Copolymer mit einer Verbindung, die eine Hydroxylgruppe besitzt, ist.

7. Positive lichtempfindliche Zusammensetzung nach einem der Ansprüche 1 bis 6, worin die hochmolekulare Substanz (A) ein Polymer, dargestellt durch die folgende allgemeine Formel (1), ist: 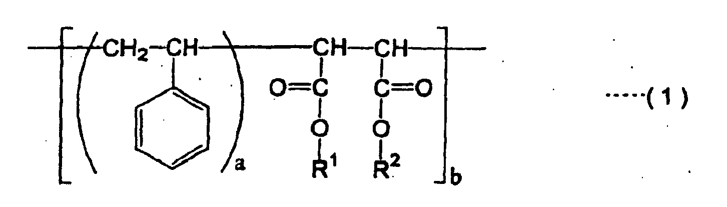 worin R¹ und R² jeweils unabhängig ein Wasserstoffatom oder eine substituierte oder unsubstituierte Alkylgruppe sind, a eine ganze Zahl von 1 bis 3 und b eine ganze Zahl von 6 bis 8 ist.

8. Positive lichtempfindliche Zusammensetzung nach Anspruch 5 oder 6, worin die Verbindung mit einer Hydroxylgruppe ein Alkohol ist.

9. Positive lichtempfindliche Zusammensetzung nach einem der Ansprüche 1 bis 8, worin die Thiolverbindung (C) 2-Mercaptobenzooxazol ist.

10. Photographisches Herstellungsverfahren, umfassend die Verwendung der positiven lichtempfindlichen Zusammensetzung nach einem der Ansprüche 1 bis 9.

11. Photographisches Herstellungsverfahren nach Anspruch 10, das auf die Herstellung einer Druckplatte, einer elektronischen Komponente, einer Präzisionsanlagenkomponente oder einer Komponente, die sich auf die Verhinderung von Fälschungen bezieht, angewandt wird.

12. Plattenherstellungsverfahren, umfassend die Verwendung der positiven lichtempfindlichen Zusammensetzung nach einem der Ansprüche 1 bis 9.

## Revendications

1. Composition photosensible positive, qui ne nécessite pas de traitement thermique après le revêtement de la composition, comprenant
(A) une substance de poids moléculaire élevé soluble dans les alcalins possédant dans sa molécule au moins un groupe carboxyle ;
(B) un matériau de conversion photothermique qui absorbe les rayonnements infrarouges provenant d'une source de lumière exposée à une image pour convertir les rayonnements en chaleur ;
(C) un composé thiol ; et
(D) un inhibiteur de dissolution, **caractérisé en ce que** l'inhibiteur de dissolution est un composé représenté par la formule chimique (2) suivante :

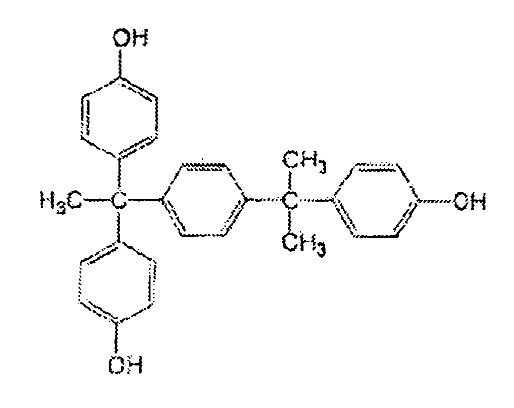

2. Composition photosensible positive selon la revendication 1, dans laquelle la substance de poids 20 moléculaire élevé (A) est au moins un polymère choisi dans le groupe constitué par un **polymère** obtenu à partir d'un composé insaturé (a1) possédant au moins un groupe carboxyle et/ou un groupe anhydride d'acide carboxylique et un **copolymère** obtenu à partir du composé insaturé (a1) et d'un composé **(a2) copolymérisable** avec le composé insaturé. 5

3. Composition photosensible positive selon la revendication 2, dans laquelle le composé insaturé (a1) est au moins un composé choisi dans le groupe constitué par l'acide maléique, l'acide **(méth)**acrylique et leurs dérivés.

4. Composition photosensible positive selon l'une quelconque des revendications là 3, dans laquelle la substance de poids moléculaire élevé (A) est au moins un polymère choisi dans le groupe constitué par un polymère d'acide maléique, un polymère d'acide (méth)acrylique, un copolymère de styrène/acide maléique et leurs dérivés.

5. Composition photosensible positive selon l'une quelconque des revendications 1 à 4, dans laquelle la substance de poids moléculaire élevé (A) est un réactif d'une substance de poids moléculaire élevé possédant un groupe anhydride d'acide carboxylique et d'un composé possédant un groupe **hydroxyle.** 25

6. Composition photosensible positive selon la revendication 4 ou 5, dans laquelle la substance de poids moléculaire élevé (A) est un copolymère de styrène/acide maléique obtenu en faisant réagir un copolymère de styrène/anhydride maléique avec un composé possédant un groupe hydroxyle.

7. Composition photosensible positive selon l'une quelconque des revendications 1 à 6, dans laquelle la substance de poids moléculaire élevé (A) est un polymère représenté par la formule générale (1) suivante : 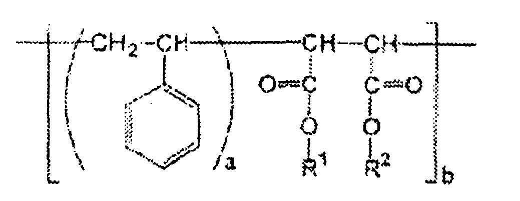 dans laquelle R"¹ et *R** représentent chacun indépendamment un atome d'hydrogène ou un groupe alkyle substitué ou non 10 substitué, a est un nombre entier allant de 1 à 3 et b est un nombre entier allant de 6 à 8,

8. Composition photosensible positive selon la revendication 5 ou 6, dans laquelle le composé possédant un groupe hydroxyle est un alcool.

9. Composition photosensible positive selon l'une quelconque des revendications là 8, dans laquelle le composé **thiol (C)** est le 2-mercaptobenzooxazole.

10. Procédé de photo-fabrication, comprenant l'utilisation de la composition photosensible positive selon l'une quelconque des revendications 1 à 9.

11. Procédé de photo-fabrication selon la revendication 10, qui est appliqué à la production d'une plaque d'impression, d'un composant électronique, d'un composant d'équipement de précision ou d'un composant associé à la dissuasion des contrefaçons.

12. Procédé de fabrication de plaque, comprenant l'utilisation de la composition photosensible positive selon l'une quelconque des revendications 1 à 9,
